## Europäisches Patentamt

## European Patent Office

## Office européen des brevets

(19)

(11) Veröffentlichungsnummer: **0 001 986**
**B1**

(12) **EUROPÄISCHE PATENTSCHRIFT**

(45) Veröffentlichungstag der Patentschrift:
25.05.83

(21) Anmeldenummer: 78101195.2

(22) Anmeldetag: 23.10.78

(51) Int. Cl.³: **H 01 L 27/08,** H 01 L 21/72,
G 11 C 11/24, G 11 C 11/34

(54) Hochintegrierte Speichermatrix und Verfahren zu ihrer Herstellung.

(30) Priorität: 11.11.77 US 850762

(43) Veröffentlichungstag der Anmeldung:
30.05.79 Patentblatt 79/11

(45) Bekanntmachung des Hinweises auf die Patenterteilung:
25.05.83 Patentblatt 83/21

(84) Benannte Vertragsstaaten:
DE FR GB

(56) Entgegenhaltungen:
DE-A-2 539 910
DE-A-2 730 202
DE-A-2 741 152
DE-A-2 741 226
FR-A-2 346 855
US-A-3 387 286
US-A-3 740 732
US-A-3 811 076
US-A-3 983 545
ELECTRONICS, Vol. 49, No. 4, February 76, New
York, J. E. COE et al »Enter the 16, 384-bit RAM«

(73) Patentinhaber: International Business Machines
Corporation, Armonk, N.Y. 10504 (US)

(72) Erfinder: Esch, Ronald Philip, 971 Shadow Brook Drive,
San Jose California 95120 (US)
Erfinder: Folsom, Robert Martin, 2414 Black Cap Lane,
Reston Virginia 22091 (US)
Erfinder: Chang-Yih, Liu, 13420 Kingsman Road,
Woodbridge Virginia 22193 (US)
Erfinder: Rideout, Vincent Leo, 3036 Knollwood Court,
Mohegan Lake New York 10547 (US)
Erfinder: Soderman, Donald Arvid, 2606 Lakevale Drive,
Vienna Virginia 22091 (US)
Erfinder: Wenning, George Thomas, 8703 Barnett Street,
Manassas Virginia 22110 (US)

(74) Vertreter: Rudolph, Wolfgang, Schönaicher Strasse 220,
D-7030 Böblingen (DE)

## Hochintegrierte Speichermatrix und Verfahren zu ihrer Herstellung

Die Erfindung betrifft eine hochintegrierte Speichermatrix aus jeweils einen Feldeffekttransistor enthaltenden Speicherzellen mit Speicherkondensatoren gemäß Oberbegriff des Patentanspruchs 1 und ein Verfahren zur Herstellung.

Aus der US-A-3 811 076 ist ein Speicher gemäß Oberbegriff des Anspruchs 1 bekannt.

Darin wird eine Speichermatrix mit Speicherzellen beschrieben, die aus einem Feldeffekttransistor mit einem in Reihe geschalteten Kondensator bestehen. Die Speicherzellen sind im Kreuzungspunkt von Wort- und Bitleitungen auf einem Halbleitersubstrat angeordnet, auf dem sich auch die peripheren Schaltkreise und Decoder in gleicher Technik befinden und inhärente, durch die Struktur bedingte Kapazitäten vorhanden sind, die als Speicherkondensator benutzt und einerseits von dem Sourcebereich des Feldeffekttransistors sowie andererseits von einer aus dotiertem Polysilicium bestehenden Leiterreferenzschicht und dem Halbleitersubstrat gebildet werden, wobei ein erster Teil dieser Leiterreferenzschicht eine Elektrode des Speicherkondensators selbst darstellt, unterhalb der der Sourcebereich angeordnet ist.

Metalloxid-Feldeffekttransistoren (MOSFETS) oder Oberflächenfeldeffekttransistoren (IGFETS) sind in Fachkreisen allgemein bekannt. In diesem Zusammenhang wird verwiesen auf den Artikel »Metal-Oxide-Semiconductor Technology« von William C. Hittinger, erschienen in der Ausgabe August 1973 auf den Seiten 48 bis 57 von Scientific American. Arbeitsweise und Herstellungsverfahren von Schaltungen unter der Verwendung von MOSFETS und IGFETS sind in zahlreichen Patenten und anderen Druckschriften beschrieben. Als Beispiel sei hier angeführt: »MOSFET in Circuit Design« von Robert H. Crawford (Texas Instruments Electronic Series) McGraw-Hill, 1967 by Texas Instruments Incorporated und »Electronics: BJTs, FETs, and Microcircuits von E. James Angelo, Jr., McGraw-Hill Electrical an Electronic Engineering Series, by McGraw-Hill 1969.

Der MOSFET oder IGFET besteht im allgemeinen aus einem ersten Halbleiterbereich, in dem Quellenbereiche und Senkenbereiche niedergeschlagen sind, die eine dem Bereich entgegengesetzte Leitfähigkeit haben. Ein Kanalbereich ist zwischen diesen beiden definiert. Die Leitfähigkeit des Kanals ist veränderlich entsprechend dem Potential, das an die kapazitiv damit gekoppelte Gate-Elektrode durch eine auf der Kanalfläche niedergeschlagene Isolierschicht angelegt wird.

In der US-Patentschrift Nr. 3 387 286 ist ein solcher Speicher aus Feldeffekttransistoren beschrieben. Dieser Speicher wird aus einer Anordnung von Speicherzellen gebildet, die zum Lesen und Schreiben durch Bit- und Wortleitungen gesteuert werden. In einem Ausführungsbeispiel wird jede Zelle durch einen FET und einen Kondensator gebildet. Die Gate-Elektrode des Transistors ist mit der Wortleitung verbunden, der Quellenanschluß mit der Bitleitung und der Drainanschluß direkt mit einer Kondensatorelektrode. Die andere Elektrode des Kondensators ist mit einem Referenzpotential verbunden. Information wird gespeichert durch Aufladen des Kondensators über dessen Transistor und wird ausgelesen durch Entladen des Kondensators über den Transistor. Während einer Schreiboperation wird die mit dem Gate des Transistors verbundene Wortleitung erregt, so daß der Transistor zwischen Quelle und Senke leitet. Wenn eine Null zu speichern ist, wird die Bitleitung nicht erregt und der Kondensator nicht geladen. Wenn eine Eins zu speichern ist, wird die Bitleitung erregt und der Kondensator wird im wesentlichen auf das Potential des Bitleitungssignales geladen. Während der Leseoperationen wird nur die Wortleitung erregt und ein Signal an die Bitleitung übertragen, wenn eine Eins vorher gespeichert wurde und der Kondensator geladen ist. Da die Ladung auf dem Kondensator mit der Zeit abfällt, muß die gespeicherte Information periodisch regeneriert werden.

In der US-Patentschrift Nr. 3 387 286 ist ein Speicher beschrieben, indem nicht eine Ladung in einem konventionellen Kondensator gespeichert wird. Es wird ein zweiter FET verwendet und die Ladung wird in der Kapazitanz zwischen Gate und Substrat dieses zweiten Transistors gespeichert. In diesem Speicher wird nichtdestruktiv gelesen, indem mit der am Gate des zweiten Transistors gespeicherten Ladung dieser Transistor leitend gemacht wird, wenn eine binäre Eins gespeichert ist, so daß das Wortleitungssignal über diesen zweiten Transistor auf die Bitabfrageleitung übertragen wird.

In der US-Patentschrift Nr. 3 720 922 wird ein Ladungskopplungsspeicher beschrieben. Das Substrat der Ladungskopplungszellen hat mehrere Speicherelektroden aus Polysilicium, die jeweils in Spaltenrichtung verlaufen und mit dem Substrat auf seiner Länge in bestimmten Abständen gekoppelt sind. Mehrere Leitungen laufen ebenfalls in Spaltenrichtung und können jeweils als Quelle eines Monoritätsladungsträgers für eine Spalte von Speicherstellen dienen. Mehrere Wortleitungen laufen in Zeilenrichtungen und sind jeweils mit einer Zeile von Speicherelektroden gekoppelt. Jede derartige Leitung steuert den Fluß von Minoritätsladungsträgern zwischen den entsprechenden Leitungen und ihren Speicherstellen auf der Wortleitung.

In der US-Patentschrift 3 740 732 ist eine Anordnung beschrieben, in der die Drain des FET mit einer Dateneingangsleitung verbunden ist und Daten am Source-Knotenpunkt des Transistors durch die inhärente Kapazitanz zwischen der Source-Diffusion und dem Substrat gespeichert werden. Die Kapazitanz der Source-Elektrode wird durch Ausbildung einer stark dotierten Schicht unter einem Teil der Source-Diffusion verstärkt. Indem das Substrat als Schaltungserde verwendet wird, kann ein Randomspeicher aus Transistoren hergestellt werden.

In der US-Patentschrift Nr. 3 699 646 ist ein Verfahren zur gleichzeitigen Ausbildung eines Kontaktes, einer Zwischenverbindung, eines Gates und einer Source oder Drain gezeigt. In einer integrierten FET-Struktur ist ein diffundierter Siliciumbereich direkt durch ein leitendes Silicium mit der Source oder Drain eines Elementes verbunden und direkt und kontinuierlich mit dem Gate eines benachbarten Elementes.

In der US-Patentschrift Nr. 3 774 176 ist ein dynamischer Halbleiterspeicher mit mehreren Ein-Transistor-Speicherelementen gezeigt, die mit einer Stellenleitung und entsprechenden Wahlleitungen, einer Auswertungs- und Regenerierungsschaltung, die ein Flipflop mit ein paar Eingangs/Ausgangspunkten enthält, von denen jeder an eine Stellenleitung angeschlossen ist, und Verbindungseinrichtungen der Punkte einschließlich eines steuerbaren Halbleiterschalters verbunden, der die Punkte auf gleiches Potential setzt, bevor aus einem selektierten Speicherelement gelesen wird.

Aus der FR-A-2 346 855 ist es bekannt, bei einem Speicher mit Speicherzellen aus Feldeffekttransistoren das Gate-Dielektrikum und das Speicherdielektrikum ausschließlich aus Oxid herzustellen.

In der US-Patentschrift Nr. 3 792 319 ist ein programmierter Festwertspeicher gezeigt, der »schmelzbare« Verbindungen aus dotiertem polykristallinem Silicium verwendet, das auf der Oberfläche einer Isolierschicht über einer integrierten Schaltung niedergeschlagen und durch Ausschnitte in der Isolierschicht und/oder eine Metallschicht verbunden ist.

Die US-Patentschrift Nr. 3 825 946 zeigt einen Feldeffekttransistor mit einem schwebenden Gate, der elektrisch geladen oder entladen werden kann. Zwei in einem bestimmten Abstand voneinander angeordnete Bereiche in einem Substrat definieren einen Kanal, über dem isoliert ein schwebendes Gate angeordnet ist. Die Bereiche haben eine dem Substrat entgegengesetzte Leitfähigkeit. Ein zweites Gate ist oberhalb und isoliert vom schwebendem Gate angeordnet. Das schwebende Gate kann elektrisch geladen werden, indem man an dem durch einen der Bereiche und das Substrat gebildeten Übergang einen Lawinendurchbruch auslöst und die Elektronen durch die Isolation in das schwebende Gate fließen läßt. Das schwebende Gate kann dadurch entladen werden, daß man an das zweite Gate eine Spannung relativ zu den voneinander entfernten Bereichen und dem Substrat anlegt, so daß die Elektronen vom schwebenden Gate durch die Isolation in das zweite Gate wandern.

Bei der in der US-Patentschrift Nr. 3 934 542 gezeigten Struktur besteht das gesamte Gate des FET aus einem Phosphorsilikatglas als Isolator und Polysilicium als Gate. Eine dünne Schicht aus Siliciumnidrid wird über dem Polysilicium ausgebildet und selektiv so weggeätzt, daß es nur über den Gatebereichen und anderen Bereichen zurückbleibt, wo es das Polysilicium als Leiter ausdehenen soll. Das nichtmaskierte Polysilicium wird zur Bildung eines dicken Oxidüberzuges oxidiert. Außerdem werden in dieser Patentschrift die Verwendung von Oxidringen und Epitaxialschichten zur Reduzierung von Störeffekten zwischen benachbarten FET's in einer integrierten Schaltung beschrieben.

In der US-Patentschrift Nr. 3 974 486 ist eine Ein-Transistor-Speicherzelle beschrieben, die im wesentlichen aus einer FET-Struktur mit negativer Widerstandscharakteristik besteht. Diese erhält man durch Ausnutzung eines Elektronenlochpaarmultiplikationseffektes, der durch eine hohe Substratdotierung in Verbindung mit entsprechender Vorspannung der Übergänge verstärkt wird.

Das US-Patent Nr. 3 983 545 zeigt einen Randomspeicher mit mehreren Gruppen von Speicherzellen, in dem jede Speicherzelle einer jeden Gruppe eine elektrische Darstellung einer binären Eins oder einer binären Null speichern kann. Außerdem ist für jede der Gruppen von Speicherzellen eine Abfrageverriegelung zur steuerbaren Abfrage einer binären Null oder Eins vorgesehen, die in einer der Speicherzellen innerhalb der Gruppe gespeichert ist. Jede dieser Abfrageverriegelungen besteht aus einem ersten direkt mit jeder Zelle einer Gruppe von Speicherzellen gekoppelten FET sowie zweiten, dritten, vierten und fünften FET's, die mit dem ersten FET verbunden sind. Außerdem sind Einrichtungen zur selektiven Steuerung der Leitung besagter erster zweiter, dritter, vierter und fünfter Transistoren vorgesehen, so daß eine binäre Eins oder Null aus einer vorbestimmten Zelle in jeder Gruppe gelesen und dorthin zurückgespeichert werden kann.

In der US-Patentschrift Nr. 617 462 werden integrierte Halbleiterschaltungen und Speicherzellen mit Feldeffekttransistoren beschrieben. Diese werden dadurch gebildet, daß man an der Oberfläche eines Halbleitersubstrates Isolationsmedien und in einem bestimmten Abstand voneinander mehrere Leiter vorsieht, die zwischen den Isolationsmedien verlaufen. Die Leiter aus polykristallinem Silicium oder Polysilicium sind vorzugsweise thermisch, chemisch oder anodisch selbstisolierend in einem nichtmaskierten Bad und werden aus einem zur Definition einer Sperre für ein Dotierungsmittel für das Halbleitersubstrat geeigneten Material hergestellt. Signalspannungen oder Vorspannungen werden an ausgewählte vorgegebene Leiter angelegt, um Steuerelektroden oder Feldabschirmungen für die Transistoren zu bekommen. Wenn auf der Substratoberfläche ein Isoliermittel aus einem Doppeldielektrikum wie Siliciumdioxid oder Siliciumnidrid niedergeschlagen ist, kann das Dotierungsmaterial durch das Isoliermaterial hindurch ionenimplantiert werden, um z. B. Source- und Drain-Elektroden der Transistoren zu bilden, wie sie durch das Isoliermittel und die Leiter definiert sind. Weitere Elemente zur Bildung einer Speicherzelle können hinzugefügt werden.

In der US-Patentschrift Nr. 671 906 ist ein Prozeß zur Herstellung von Transistorspeicherzellen beschrieben, in dem ein dünnes Oxid zusammenhängend über dem ganzen Bereich ausgebildet wird, daß auch zusammenhängend von der Niederschlagszeit an geschützt ist, so daß nachfolgende Prozeßschritte die Dicke nur an den beabsichtigten Stellen verändern. Der Prozeß besteht aus einer ausgewählten Kombination von Materialniederschlag, Maskierung mit Photolack, Eloxierung und Ätzung. Zuerst wird ein Maskierungsschutzfilm niedergeschlagen und dieser hinterher in einer Reihe von Schritten so entfernt, daß er im Farbrikationsprozeß verloren geht und die doppelten dielektrischen Isolierschichten entfallen. Dadurch kann die Leistung und Dichte der Schaltungsgruppen verbessert werden. Halbleitergruppen einschließlich FET's und Speicherzellen mit FET's werden dadurch gebildet, daß man an der Oberfläche eines Halbleitersubstrats Isolationslinien und in einem bestimmten Abstand voneinander mehrere Leiterlinien orthogonal zu den Isolationslinien anordnet. Die Leiterlinien sind vorzugsweise anodisch selbst islierend. Signalspannungen oder Vorspannung werden an ausgewählte Leiterzüge angelegt, um Steuerelektroden oder Feldabschirmungen für die Transistoren zu bekommen. Wenn auf der Oberfläche des Substrates ein Isoliermaterial niedergeschlagen ist, wie etwa Siliciumdioxid, kann das Dotierungsmaterial durch das Isoliermaterial hindurch ionenimplantiert werden, um z. B. Source- und Drainelektroden der Transistoren zu bilden. Andere Bauelemente können der Struktur beispielsweise zur Bildung einer Speicherzelle hinzugefügt werden.

Die Aufgabe der Erfindung besteht darin, eine sehr dicht gepackte Anordnung monolithischer Speicherzellen mit verbesserter Leistung einer jeden Zelle und des gesamten Speichers, wobei jede Zelle einen Feldeffekttransistor enthält, sowie ein verbessertes Verfahren zu deren Herstellung zu schaffen.

Die Aufgabe der Erfindung wird insbesondere gelöst durch die im Kennzeichen des Anspruchs 1 angegebenen Merkmale.

Das Verfahren zur Herstellung wird insbesondere durch die Prozeßschritte gemäß Anspruch 4 geprägt.

Die Verwendung eines dünnen Oxids als Gatedielektrikum, diffundierter Bitleitungen, Metallwortleitungen sowie die versetzte Anordnung der Zellen in vorgegebener Konfiguration verbessern die Packungsdichte des Speichers weiter, ohne die verbesserte Leistung der Speicheranordnung zu vermindern. Weiterhin schafft die Erfindung ein verbessertes Herstellungsverfahren für den Speicher, das nur eine begrenzte Anzahl von Maskierungsschritten verlangt, die alle innerhalb des heutigen Standes der Technik liegen und eine bessere Ausrichtung des Gates liefern. Die Erfindung läßt sich vorteilhaft auch auf andere als die beschriebenen Strukturen und Speicherzellen anwenden. Als Beispiele seien hier programmierte logische Schaltungsanordnungen (PLA's) in integrierter Schaltungsbauweise, Mikroprozessoren, logische Schaltungen und dergleichen genannt, die vorzugsweise Feldeffekttransistoren verwenden.

Weiterhin gestattet der Einschluß und der Einfluß eines Polysiliciumleiters für eine Platte des dünnen Oxidspeicherkondensators einer jeden Speicherzelle die Überlappung von Metallwortleitungen.

Ausführungsbeispiele der Erfindung sind in den beigefügten Zeichnungen dargestellt und werden anschließend näher beschrieben.

Es zeigen:

Fig. 1 einen Lageplan der Fig. 1A und 1B zur Darstellung eines erfindungsgemäßen monolithischen Speichers,

Fig. 1C einen Lageplan der Fig. 1D, 1E und 1F, die Einzelheiten eines Teiles des in Fig. 1 dargestellten monolithischen Speichers zeigen,

Fig. 2 eine teilweise geschnittene Draufsicht des monolithischen Speichers und eine zweite Anordnung der Speicherzelle,

Fig. 2A eine Schnittansicht entlang der Linie 2-2 in Fig. 2, die

Fig. 3A bis 3M Schnittansichten eines ersten Teiles eines erfindungsgemäßen monolithischen Speichers nach den aufeinanderfolgenden Prozeßschritten des erfindungsgemäßen Prozesses,

Fig. 4A bis 4F zusammen betrachtet mit Fig. 3A bis 3M ausgewählte Schnittansichten eines zweiten Teiles des erfindungsgemäßen monolithischen Speichers und der erwähnten Prozeßschritte,

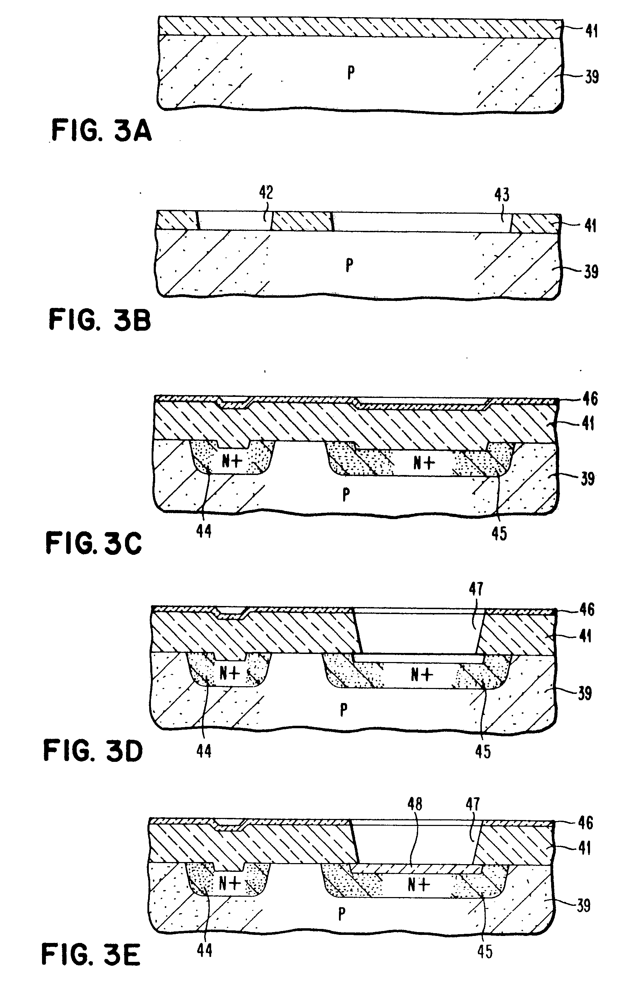

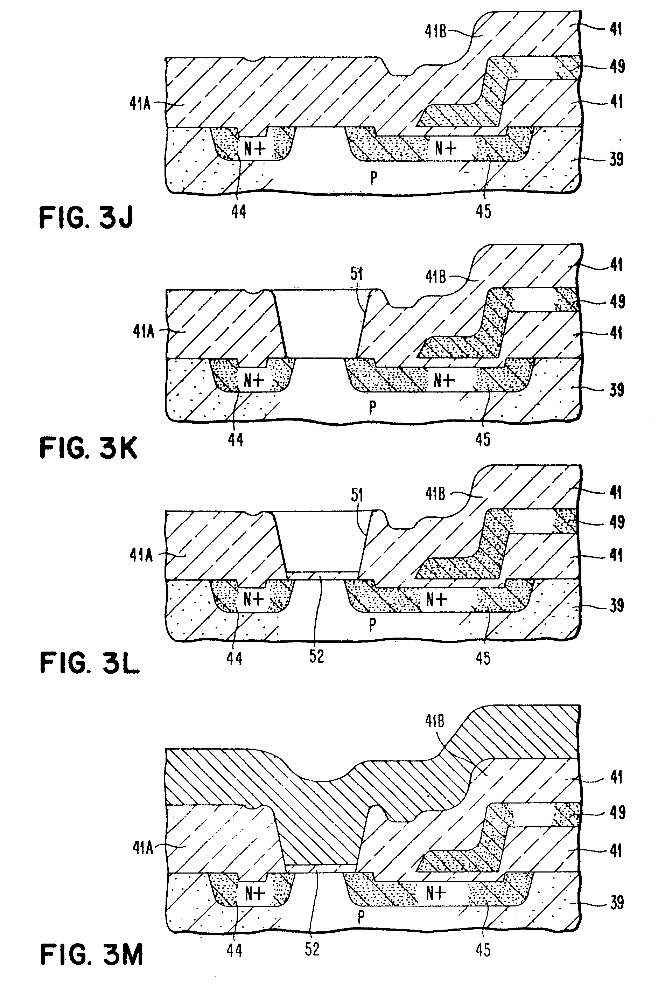

Fig. 3A das Aufwachsen einer ersten Thermooxidschicht auf einem P-leitendem Halbleitersubstrat,

Fig. 3B die Öffnung eines ersten und zweiten Ausschnittes in einem bestimmten Abstand voneinander in der Oxidschicht zur Definition der Endlosbereiche,

Fig. 3C die N-leitende Dotierung des ersten und zweiten Bereiches auf der Halbleitersubstratfläche durch die Ausschnitte, das Wachsen einer Oxidschicht und der Niederschlag von Phosphorsilicatglas in einer Behandlung mit $PSCl_3$ in der Größenordnung von 5% Phosphor,

Fig. 3D die Öffnung eines kleineren Ausschnittes in der über dem zweiten dotierten Bereich des Halbleitersubstrats liegenden Oxidschicht,

Fig. 3E das Wachsen einer dünnen Oxidschicht auf besagtem zweiten dotiertem Bereich durch besagten Ausschnitt,

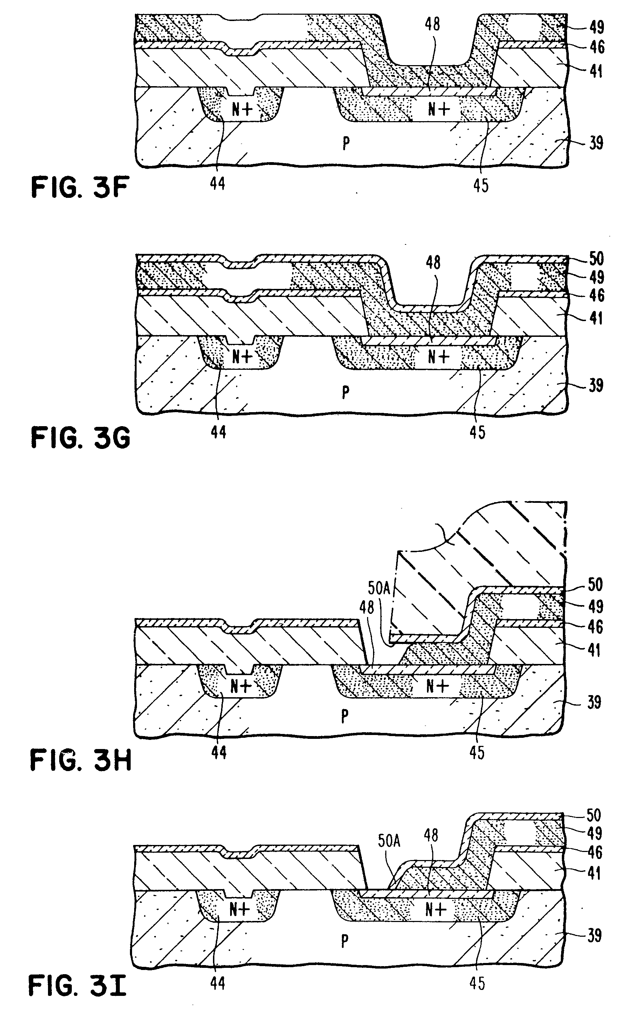

Fig. 3F das Niederschlagen einer Polysiliciumschicht auf der freiliegenden Oberfläche des Substrates,

Fig. 3G eine N-Dotierung der Polysiliciumschicht durch eine Schicht aus Phosphorsilicat und eine anschließende Wärmebehandlung während des Wachsens einer Oxidschicht auf der Polysiliciumschicht,

Fig. 3H die Entfernung eines ausgewählten Teiles der letzten aufgewachsenen Oxidschicht, abgegrenzt mit einer Photoresistschicht, und die Entfernung eines ausgewählten Teiles der dotierten Polysiliciumschicht mit einer geätzten Oxidschicht als Maske,

Fig. 3I einen kleinen freigelegten Erweiterungsteil der verbleibenden Phosphorsilicat-Glasschicht, der sich plastisch verformt und so teilweise einen freiliegenden Bereich der verbliebenen dotierten Polysiliciumschicht abdeckt,

Fig. 3J das Wachsen einer dicken Oxidschicht über der freiliegenden Strukturfläche,

Fig. 3K die Öffnung eines Ausschnittes in der Oxidschicht zur Substratfläche zwischen dem genannten ersten und zweiten Bereich,

Fig. 3L das Niederschlagen einer dünnen Oxidschicht (Gatedielektrikum) auf der Substratfläche, die durch besagten Ausschnitt freigelegt wurde,

Fig. 3M die Anordnung einer Metallwortleitung als integrierter Teil der Gateelektrode,

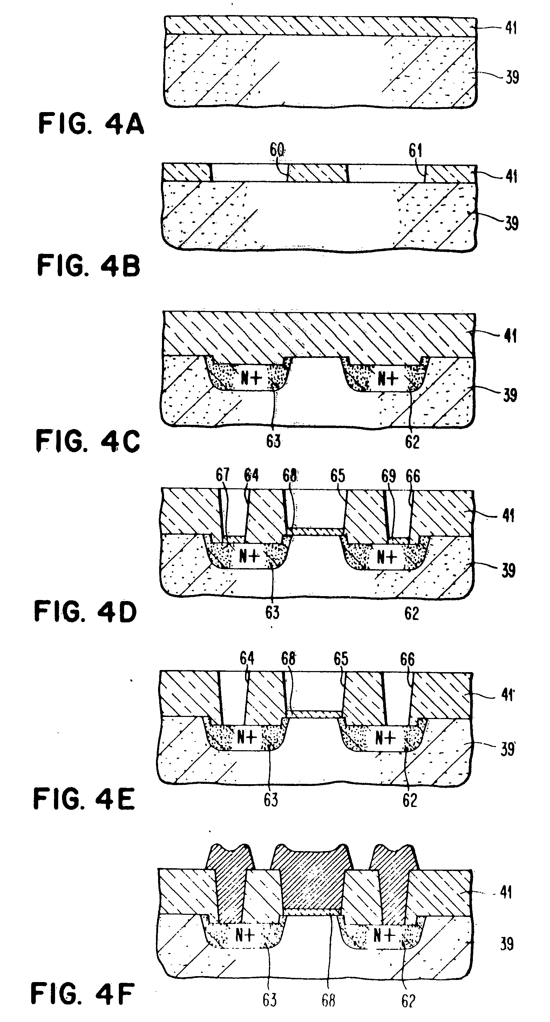

Fig. 4A das Wachsen einer ersten Thermooxidschicht auf einem P-leitendem Halbleitersubstrat,

Fig. 4B die Öffnung eines ersten und zweiten Ausschnittes in der Oxidschicht in einem bestimmten Abstand voneinander,

Fig. 4C die Dotierung eines ersten und zweiten Bereiches der Halbleitersubstratfläche über die Ausschnitte und das anschließende Wachsen einer Oxidschicht über der freiliegenden Strukturfläche,

Fig. 4D die Öffnung eines ersten, zweiten und dritten Ausschnittes in besagter Oxidschicht in einem bestimmten Abstand voneinander und die Anordnung einer dünnen Oxidschicht über der Substratfläche, die durch jeden der Ausschnitte freigelegt wurde. (Die drei Ausschnitte legen einen Teil besagten ersten dotierten Bereiches und einen Teil der Substratfläche zwischen dem ersten und zweiten dotierten Bereich sowie einen Teil des besagten zweiten dotierten Bereiches frei.)

Fig. 4E die Entfernung der auf der Halbleiterfläche, die durch besagten ersten und dritten Ausschnitt freigelegt wurde, niedergeschlagenen dünnen Oxidschicht (Gatedielektrikum), so daß die durch besagten zweiten Ausschnitt niedergeschlagene dünne Oxidschicht übrigbleibt und

Fig. 4F die Anordnung eines Metallkontaktes zu dem ersten dotierten Bereich (Drain), einer Metallgateelektrode über besagtem Gatedielektrikum und eines Metallkontaktes zu dem zweiten dotierten Bereich (Source).

Anmerkung: Die in den Fig. 3G und 3H gezeigten Prozeßschritte können auch in umgekehrter Reihenfolge ausgeführt werden, so daß das Polysiliciummuster weggeätzt wird, bevor die Phosphorsilicat-Glasschicht niederschlagen und das Polysilicium N-leitend dotiert wird.

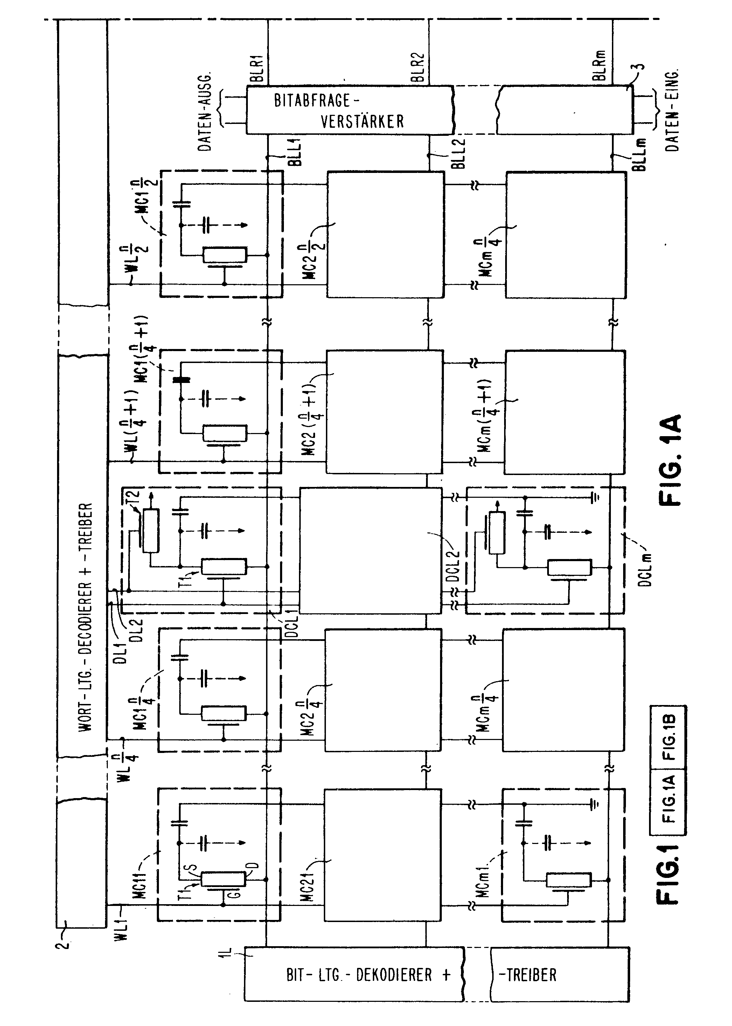

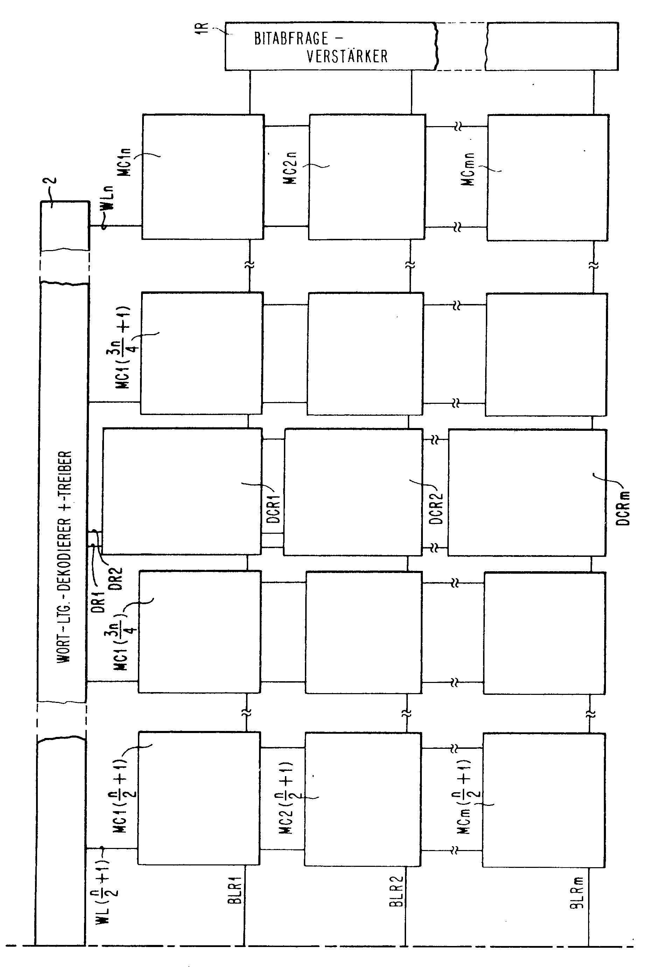

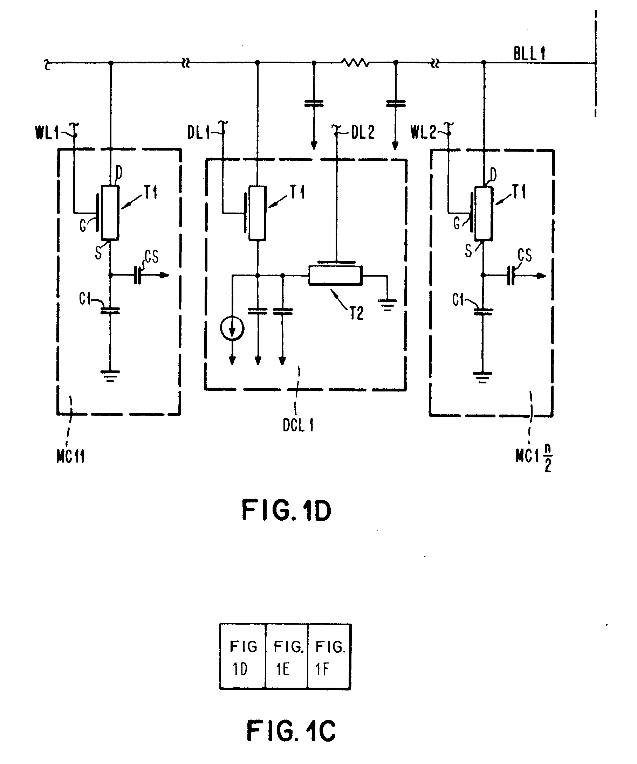

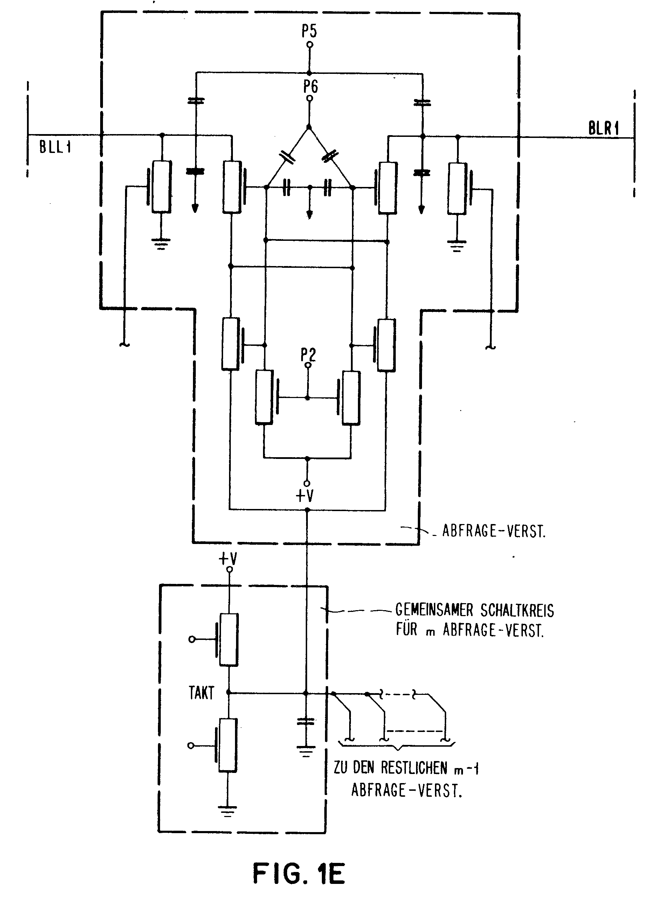

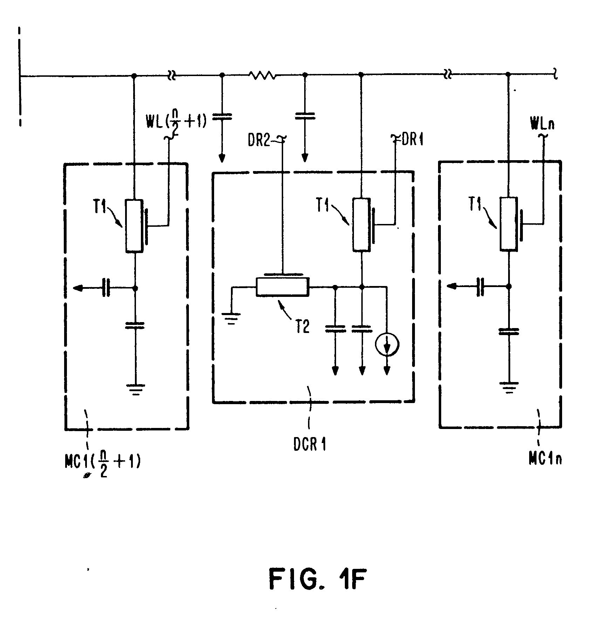

Der schematisch in Fig. 1 gezeigte Speicher ist eine Anordnung von Speicherzellen MC in n-Spalten und m-Zeilen. Die Speicherzellen in den Spalten 1 bis n sind entsprechend mit den Wortleitungen WL1 bis WLn verbunden.

Die Speicherzellen in den Zeilen 1 bis m sind entsprechend mit Bitleitungen BLL1 und BLR1 bis BLLm und BLRm verbunden. Man kann also jede Zelle in dieser m · n Anordnung adressieren, indem man die betreffende mit der zu adressierenden Zelle verbundene Wortleitung und die Bitleitung ansteuert.

In Fig. 1 ist eine erste Spalte mit Blindzellen DCL1 bis DCLm vorgesehen, die vorzugsweise in Wirklichkeit zwischen den Speicherzellen Spalten

$$\frac{n}{4} \text{ und } \frac{n}{4} + 1$$

liegen. Eine zweite Spalte mit Blindzellen DCR1 bis DCRm ist ebenfalls vorgesehen und liegt vorzugsweise zwischen den Speicherzellen Spalten

$$\frac{3n}{4} \text{ und } \frac{3n}{4} + 1 .$$

Die Blindzellen DCL1 bis DCLm sind entsprechend durch die Leitungen DL1 und DL2 mit dem Wortleitungsdecodierer und -treiber 2 verbunden. Außerdem sind die Blindzellen DCL1 bis DCLm mit einer entsprechenden Bitleitung BLL1 bis BLLm verbunden. Die Blindzellen DCR1 bis DCRm sind durch die Leitungen DR1 und DR2 mit dem Wortleitungsdecodierer und -treiber 2 und jede auch mit einer entsprechenden Bitleitung BLR1 bis BLRm verbunden. Jede der Wortleitungen WL1 bis WLn verbindet eine vorgegebene Speicherzelle der Spalten 1 bis n mit dem Wortleitungsdecodierer und -treiber 2. Jede der Bitleitungen BLL1 bis BLLm verbindet eine vorgegebene Zelle des m-Bitabfrageverstärkers 3 und des Bitleitungsdecodierers und -treibers 1L. Jede der Bitleitungen BLR1 bis BLRm ist mit einem vorgegebenen der m-Bitabfrageverstärker 3 und dem Bitdecodierer und -treiber 1R verbunden.

Abgesehen von Prozeßtoleranzen, Abweichungen usw. ist jede der Speicherzellen MC11 bis MCmn in Fig. 1 identisch. Jede dieser Speicherzellen ist außerdem auf gleiche Weise mit der Wortleitung und der Bitleitung verbunden. Jede der in Fig. 1 gezeigten Speicherzellen enthält also einen Feldeffekttransistor T1, einen integrierten Kondensator C1 und einen parasitären Kondensator CS. Der integrierte Kondensator C1 wird als integrierter Teil einer aus FET-Struktur mit T1 und CS hergestellt, wobei CS die verteilte parasitäre Kapazitanz der Source S von T1 bezüglich des Substrates ist. Der Kondensator CS ist zwischen der Source S von T1 und dem Substrat gestrichelt dargestellt. Die gestrichelten Linien bedeuten, daß dem monolithischen Speicher für die Kapazitanz CS kein besonderes Element hinzugefügt wird, sondern es sich hier um eine der monolithischen Strukturen inhärente, verteilte Streu- oder Parasitärkapazität handelt. Der integrierte Kondensator C1 ist zwischen der Source S und einem Referenzpotential (Erde) angeschlossen. Er kann als aus einer ersten Platte, die die Source S von T1 ist, und einer zweiten Platte, einer Polysiliciumschicht, die im weiteren Referenzebene genannt wird, bestehend angesehen werden. Die Zelle MC11 in Fig. 1 ist weiterhin mit ihrer Gateelektrode G von T1 an die Wortleitung WL1 und mit der Drain D von T1 mit der Bitleitung BLL1 verbunden.

Abgesehen von Prozeßtoleranzen, Abweichungen usw. sind die Blindzellen DCL1 bis DCLm und DCR1 bis DCRm miteinander identisch. Die in Fig. 1 gezeigte Blindzelle DCL1 enthält wie jede andere einen Feldeffekttransistor T1, einen Feldeffekttransistor T2, einen Kondensator C1 und einen Kondensator CS. Die Bauteile T1, C1 und CS entsprechen denselben Bauteilen der oben beschriebenen Speicherzellen und sind genauso untereinander verbunden.

In den Blindzellen legt jedoch der zusätzliche FET T2 den integrierten Kondensator C1 in Nebenschluß. Das Gate von T1 in der Blindzelle DCL1 ist mit der Leitung DL2 und das Gate von T1 mit der Leitung DL1 verbunden. Entsprechend sind die Blindzellen DCL2 bis DCLm mit den Leitungen DL1 und DL2 und die Blindzellen DCR1 bis DCRm mit den Leitungen DR1 und DR2 verbunden.

Der Wortleitungsdecodierer und -treiber 2, der Bitleitungsdecodierer und -treiber 1L, der Bitleitungsdecodierer und -treiber 1R und die m Bitabfrageverstärker 3, die die n Wortleitungen und die m Bitleitungen benutzen, sind zeitlich so gesteuert, daß die in der Anordnung von n · m Speicherzellen gespeicherte binäre Information gelesen, geschrieben und regeneriert wird. Die Benutzung von Blindzellen in einem monolithischen Speicher ist bekannt (siehe z. B. US-Patentschrift Nr. 3 992 704 und Nr. 3 838 295). Der Wortleitungsdecodierer und -treiber 2, der Bitleitungsdecodierer und -treiber 1L und der Bitleitungsdecodierer und -treiber 1R können auf für solche Schaltungen bekannte Weise logisch verbunden werden. Eine detailierte Beschreibung der Schaltungs- und Funktionsweise dieser peripheren Schaltkreise erscheint überflüssig, da sie dem allgemeinen Stand der Technik entsprechen.

Die m Bitleitungsabfrageverstärker sind in Fig. 1 durch den Block 3 dargestellt. Jeder dieser Verstärker ist in der logischen Schaltung und Struktur vorzugsweise identisch. Außerdem stellt der Block 3 in Fig. 1 die für die Verstärker allgemein übliche Steuer- und Taktschaltung dar. Jeder der m-Bitleitungsabfrageverstärker ist mit einem separaten Bitleitungspaar verbunden, also mit BLL1 und BLR1, BLL2 und BLR2 ... BLLm-1 und BLRm-1 und BLLm und BLRm. Bitleitungsabfrageverstärker sind in Schaltung und Struktur hinreichend bekannt. Im Zusammenhang mit Fig. 1C wird anschließend die Arbeitsweise einer erfindungsgemäßen monolithischen Speichermatrix beschrieben.

Ein erfindungsgemäßer Speicher wird durch eine Anordnung von Speicherzellen gebildet, die zum Lesen und Schreiben über angeschlossene Wort- und Bitleitungen gesteuert werden.

Jede Speicherzelle besteht aus einem Feldeffekttransistor und einem integrierten Kondensator. Die Gateelektrode des Transistors ist mit der Wortleitung, der Drainanschluß mit der Bitleitung und der Sourceanschluß direkt mit einer Elektrode des Kondensators verbunden, dessen andere Elektrode an ein Referenzpotential gelegt ist. Jede Wortleitung ist an ein Wortleitungsdecodierer geführt, jede Bitleitung an einen Bitleitungsdecodierer und einen Abfrageverstärker. Mit jeder Bitleitung und einer logischen Schaltung innerhalb des Wortleitungsdecodierers ist eine Blindzelle verbunden.

Der durch die Erfindung vorgesehene Speicher ist in integrierter Schaltungsbauweise ausgeführt, in der jede Zelle eine sehr kleine Fläche auf dem Halbleitersubstrat belegt. So läßt sich auf einem einzigen Substrat ein sehr großer Speicher mit vielen Zellen herstellen und mit sehr hoher Geschwindigkeit betreiben. Im Ausführungsbeispiel ist n = m = 128, so daß der Speicher 16 384 Speicherzellen enthält und als 16K Speicher bezeichnet wird. Der Speicher speichert binäre Information durch Speicherung einer Ladung auf einem Kondensator, der in integrierter Schaltung ausgeführt ist. Obwohl diese Art der Speicherung im Sinne einer Speicherung in einer Verriegelungsschaltung oder einem Magnetkern nicht beständig ist, da die Ladung mit der Zeit entweicht, erwies sich die Zeit, in der die Ladung einen ausreichenden Wert beibehält als sehr groß im Vergleich zu der Lese/Schreib-Zykluszeit für diesen Speicher. Auch wenn die gespeicherte Information periodisch regeneriert werden muß, braucht die Regenerierung nur 10 bis 20% der Zeit und der Speicher wird in den übrigen 80% für konventionelle Operationen genutzt. Lese/Schreibzyklen von 200 bis 1000 Nanosekunden stehen zur Verfügung und trotz der notwendigen Regenerierung erhält man so insgesamt einen Speicher mit einer Lese/Schreibzykluszeit, die gemessen an der tatsächlichen Nutzung in der Nähe von 100 bis 1000 Nanosekunden liegt.

Die Arbeitsweise des monolithischen erfindungsgemäßen Speichers wird im einzelnen anschließend mit den Fig. 1 und 1C erklärt.

In Fig. 1E ist die Arbeitsweise des Abfrageverstärkers der Speicherzellen-Bitleitungen dargestellt. Während der Schreiboperation wählt der Bitleitungsdecodierer eine bestimmte Bitleitung und hält die rechte Seite entweder auf Eins oder auf Null. Der bistabile Abfrageverstärker verriegelt dann und zwingt eine Seite hoch und die andere nach unten. Der Wortleitungsdecodierer wählt dann eine der Wortleitungen, die den einzelnen Speicherknotenpunkt mit der Bitleitung koppelt. Nach einer Eingangsoperation (Bootstrap Operation) zur Erhöhung der gespeicherten Ladung fällt die Spannung auf der Wortleitung ab und isoliert so den Speicherknotenpunkt.

Gemäß Darstellung in Fig. 1E laden die verschiedenen Taktsignale im Abfrageverstärker beide Seiten des Abfrageverstärkers auf ungefähr dieselbe Spannung auf (Spannungsdifferenzen hängen von den $V_T$-Werten der beiden über Kreuz gekoppelten FET's ab, die ebenfalls zum Abfragen benutzt werden). Der Wortleitungsdecodierer wählt dann eine Zelle auf der Bitleitung und die kleine Ladung wird dann abhängig vom gespeicherten Potential neu verteilt. Für eine logische Null nimmt die Bitleitungsspannung ab.

Gleichzeitig wird eine Blindzelle mit nur der halben Speicherkapazität auf der gegenüberliegenden Seite des Abfrageverstärkers adressiert. Diese Blindkapazitanz wird am Anfang vor jedem Zyklus entladen und führt zu einem ganz kleinen Abfall der Bitleitungsspannung. Der Abfrageverstärker fühlt diese relative Potentialdifferenz ab (± abhängig von der gespeicherten Information) und verriegelt die Verriegelungsschaltung. Der Abfrageverstärker ist so empfindlich, daß die Ladung für eine am Anfang gespeicherte logische Eins durch Leckströme abfallen und unter normalen Bedingungen immer noch richtig als eine logische Eins gelesen werden kann. Da eine logische Null am Anfang bei einer sehr niedrigen Spannung gespeichert wird, liest der Abfrageverstärker richtig bei jedem durch Spannungsabfall induzierten Leckstrom.

Während eines Zyklus werden alle Zellen auf einer Wortleitung adressiert und die Knotenpunktspannung wird gleichzeitig durch die einzelnen Abfrageverstärker wieder hergestellt (aufgefrischt). Der Bitleitungsdecodierer wird dann betätigt, um die auf der jeweiligen Bitleitung gespeicherte Information auszulesen. Da der Abfrageverstärker als Inverter wirkt und Information immer auf der rechten Bitleitung eingeführt und ausgelesen wird, wird eine logische Eins tatsächlich als ein hoher/niedriger Pegel auf den Speicherzellenstellen auf der rechten/linken Seite gespeichert. Diese Inversion ist für den Speicherbenutzer transparent.

Da Leckströme schließlich die auf dem Kondensator gespeicherte Ladung entladen, müssen die Zellen periodisch aufgefrischt werden. In einem Auffrischungszyklus kann ein interner Zähler die Bitleitungsadressen durchlaufen, so daß eine maximale Zellenhaltezeit garantiert ist.

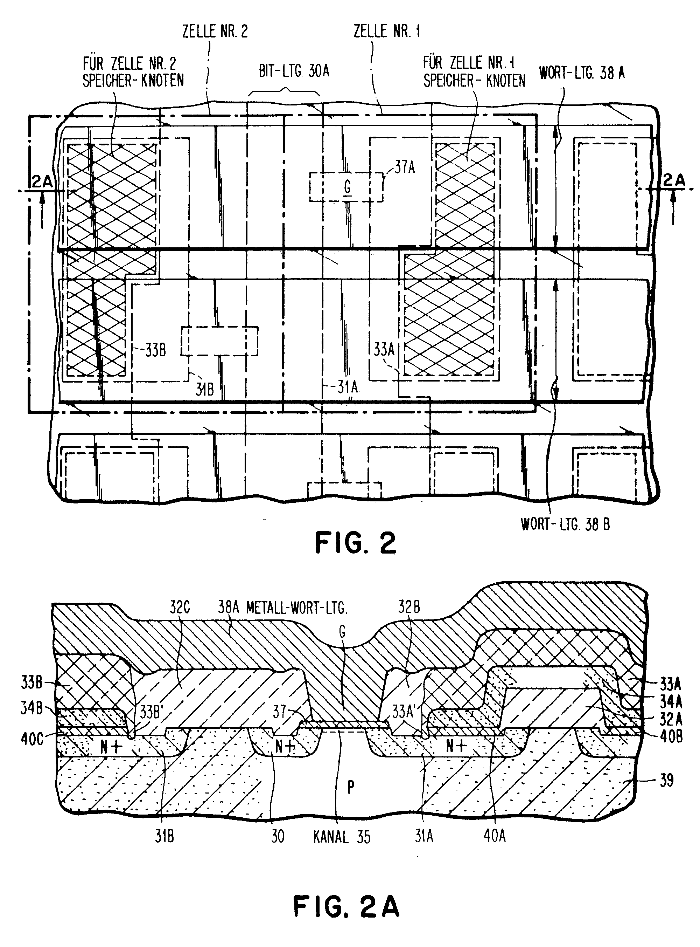

In den Fig. 2 und 2A ist ein Teil der Zellenanordnung eines erfindungsgemäßen monolithischen Speichers gezeigt. Fig. 2 zeigt eine Draufsicht mit einer ersten und zweiten Speicherzelle und Fig. 2A eine Schnittansicht entlang der Linie 2A-2A in Fig. 2. In Fig. 2 stellen die durch gestrichelte Linien und die Bezeichnung Zelle Nr. 1 und Zelle Nr. 2 dargestellten Bereiche die von jeder Speicherzelle belegte Halbleiterfläche dar, die ungefähr 0,645 mm² beträgt. Das in Fig. 2A gezeigte, vorzugsweise P-leitende Substrat 39 hat eine Dotierungskonzentration von $7 \cdot 10^{15}$ Bor-Atome/cm³ und einen N+-Bereich 30. Der N+-Bereich 30 hat an der Oberfläche eine Dotierungskonzentration von $10^{21}$ Phosphor-Atomen/cm³. Wie aus Fig. 2 zu ersehen ist, fungiert der längliche N+-Bereich 30 als diffundierte Bitleitung 30A und hat auch eine Elektrode, die hier als Drain einer jeden zugehörigen FET-Speicherzelle bezeichnet wird. Der N+-Bereich 31A ist die Source der Speicherzelle, hat eine Oberflächen-Dotierungskonzentration von $10^{21}$ Phosphor-Atomen/cm³ und wird gleichzeitig mit dem Bereich 30 ausgebildet. Das Gatedielektrikum 37 ist vorzugsweise Siliciumdioxid mit einer Dicke von etwa 50 nm. Die vom Kanal 35 durch das Gate-Dielektrikum 37 getrennte Gateelektrode G wird vorzugsweise mit der Metallwortleitung 38A integriert ausgebildet. Bei dem Metall handelt es sich um eine Kupfer-Aluminiumlegierung. Die Metall-Gateelektrode ist ungefähr genauso lang wie der Abstand zwischen dem Drainbereich 30 und dem Source-Bereich 31A. Die Metall-Gateelektrode ist von der Oberfläche des Substrates 39 und vom Kanal 35 durch eine Siliciumdioxidschicht 37 getrennt. Die Fläche des Gate, Breite × Länge, entspricht ungefähr der von der unterbrochenen Linie 37A in Fig. 2 eingeschlossenen Fläche. Eine dotierte Polysilicium-Referenzebene 34A liegt, wie aus Fig. 2A zu sehen ist, über einer mit 500 nm relativ dicken, thermisch aufgewachsenen Siliciumdioxidschicht 32A, die parallel zur Bitleitung 30A verläuft und neben dieser liegt. Außerdem läuft die Referenzebene 34A parallel zur Bitleitung 30A und hat ein regelmäßiges Muster mit mehreren Teilen in der allgemeinen Form einer Eins, die von einem N+-Bereich (Source) auf dem Substrat durch eine Siliciumdioxidschicht 40A mit einer Dicke von ungefähr 50 nm getrennt sind. Jeder dieser Teile in Form einer Eins einer Referenzebene fungiert als Teil des Speicherknoten einer Speicherzelle. In Fig. 2 entspricht ein solcher Teil der Referenzebene 34A in der Konfiguration dem schraffierten Bereich mit der Bezeichnung »Zelle Nr. 1 Speicherknoten« und der Eins-Formteil einer Referenzebene 34B entspricht in der Konfiguration dem schraffierten Bereich mit der Bezeichnung »Zelle Nr. 2 Speicherknoten«.

Über der Referenzebene 34A liegt eine Polysiliciumdioxidschicht 33A und über der Referenzebene 34B liegt eine Polysiliciumdioxidschicht 33B. Die dotierten Polysilicium-Referenzebenen sind relativ gute elektrische Leiter während die Polysilicium-Oxidschichten als Isolatoren dienen. Die Bereiche 32B und 32C sind thermisch aufgewachsene Oxide, deren Dicke vorzugsweise in der Größenordnung von 740 nm liegt. Die Siliciumdioxidschichten 40A bzw. 40B und 40C trennen die dotierten Polysilicium-Referenzebenen von den N+-Sourcebereichen. Die Siliciumdioxidschichten 40A, 40B bzw. 40C haben eine Dicke von je ungefähr 50 nm. Der Teil 33A' einer Polysiliciumoxidschicht 33A umfaßt die Kanten der Referenzebene 34A und der Oxidschicht 40A, ein Teil 33B' der Polysiliciumoxidschicht 33B umfaßt die Kanten der Referenzebene 33B und der Oxidschicht 40C. Wie genauer aus Fig. 2 zu sehen ist, liegt der Source-Bereich 31A unter dem 1-Formteil der Referenzebene und geht über diesen hinaus. Der Speicherknoten einer jeden Zelle wird so im wesentlichen durch den 1-Formteil des dotierten Polysiliciums gebildet, der vom Source-Bereich durch eine dünne Oxidschicht getrennt ist. Jede Metallwortleitung mit Ausnahme der Gateelektroden wird auf elektrisch nicht leitendem Material überlagert. Die Metallwortleitung 38 A wird beispielsweise durch eine Isolierschicht getragen, die aus Polysiliciumdioxid und Siliciumdioxid besteht (wie aus der Beschreibung der Fig. 3A bis 3M noch hervorgeht, können die Polysiliciumschichten 33A und 34 ersetzt werden durch eine ausreichend dicke Schicht aus Siliciumdioxid). Die Wortleitungen in Fig. 2 überlagern die Speicherknotenteile einer jeden Speicherzelle Nr. 1 und Nr. 2. Die Zellenanordnung nach dem Ausführungsbeispiel der Fig. 2 gestattet eine dichtere Anordnung der Wortleitungen im Speicher und trägt somit zur höheren Speicherdichte bei, weil Verdrahtungsspuren oder -kanäle fehlen, da die Wortleitungen den Speicherzellen überlagert werden können und so die Dichte etwa um den Faktor 2 verbessert werden kann.

In den Fig. 3A bis 3M ist ein Herstellungsverfahren für einen erfindungsgemäßen Speicher dargestellt, das anschließend genauer beschrieben wird.

Fig. 3A zeigt, wie auf einem P-leitendem Siliciumsubstrat 39 mit 2 Ohm-Zentimeter eine Siliciumdioxidschicht 41 in einer Dicke von etwa 300 nm auf konventionelle Art bei 1000°C in einem feuchten Thermooxidprozeß aufgewachsen wird.

In Fig. 3B ist die Struktur der Fig. 3A nach einem ersten konventionellen Photomaskierungsschritt gezeigt, in den in bekannter photolithographischer Technik zwei Ausschnitte 42 und 43 in die Siliciumdioxidschicht 41 geätzt werden, die dann die Drain (gemeinsame Bitleitung) und die Source (Speicherknotenpunkt) der Speicherzelle bilden.

In Fig. 3C sind die folgenden Schritte gezeigt, mit denen man zu der in Fig. 3 gezeigten Struktur gelangt. Die n-Dotierung (Phosphor) wird durch die Ausschnitte 42 und 43 eingeführt und liefert die N+-Bereiche 44 und 45 in einem herkömmlichen n-Dotierungsschritt von POCl₃ mit nachfolgender Oxidation und einem thermischen Eintreibeschritt. Das Thermooxid wird aufgewachsen, um die Schicht 41 auf ungefähr 500 nm Dicke anwachsen zu lassen, wobei die oberen 100 nm viel Phosphorsilicatglas enthalten, das auf der Oberfläche der thermisch gewachsenen Oxidschicht zur Phosphorsilicat-Glasschicht 46 ausgebildet wird. Während des Aufwachsens des Thermooxides werden die n-Verunreinigungen weiter hineingetrieben und diffundiert.

In Fig. 3D ist der zweite konventionelle Photomaskierungsschritt des Prozesses gezeigt. Unter Anwendung bekannter photolithographischer und Oxidätztechniken wird der Ausschnitt 47 geschaffen, der die Lage des Speicherkondensators definiert.

In Fig. 3E ist gezeigt, wie eine dünne Oxidschicht 48 im Ausschnitt 47 auf dem N+-Bereich 45 zur Bildung des Speicherplatten-Kondensatordielektrikums thermisch aufgewachsen wird. Die Oxidschicht 48 ist 50 bis 80 nm dick und wird vorzugsweise im trockenen Oxidationsprozeß gewonnen.

Fig. 3F zeigt das Niederschlagen einer Polysiliciumschicht 49 auf allen freiliegenden Flächen der Struktur durch konventionelles Niederschlagen chemischer Dämpfe bei einer Temperatur von ungefähr 650°C.

In Fig. 3G ist gezeigt, wie die Polysiliciumschicht 49 mit n-Verunreinigungen dotiert wird. In dem allgemein bekannten Dotierungsprozeß wird insbesondere POCl₃ bei 870°C dotiert und hinterher in einem Hochtemperaturschritt eingetrieben. Das Polysilicium kann auch durch Ionenimplantation mit Phosphor zur Erzielung einer n-Leitfähigkeit dotiert werden. Während der Dotierung mit POCl₃ wird unter den beschriebenen Prozeßbedingungen auf der Polysiliciumschicht 49 eine dünne Oxidschicht 50 aus Phosphorsilicatglas als Maskenschicht thermisch aufgewachsen.

Fig. 3H zeigt die Struktur in der dritten Photomaskenstufe des Prozesses. Das Photoresistmaterial P. R. ist in Fig. 3H der einfacheren Erklärung halber nur angedeutet. In bekannter Photolithographietechnik wird zu Anfang der freiliegende Teil der Schicht 50 mit gepufferter HF weggeätzt. Danach wird das geätzte Bild der Oxidschicht 50 als Maske zum Ätzen der Polysiliciumschicht 49 benutzt. Das Polysilicium wird mit einer Ätzlösung aus Äthylen-Diamin-Pyrokathechol geätzt, die nach Darstellung in Fig. 3H einen Teil der verbliebenen Schicht 50 unterschneidet und einen unterätzten erweiterten Teil 50A der Photosilicatglasschicht 50 zurückläßt.

In Fig. 3I ist der erweiterte unterätzte Teil 50A der Maskenschicht 50 plastisch so verformt gezeigt, daß er den freiliegenden Teil der dotierten Polysiliciumschicht 49 überlagert. Die plastische Verformung erfolgt eigentlich während des nächsten Prozeßschrittes bei einer Temperatur von ungefähr 900°C. Fig. 3I ist ausdrücklich gezeigt, um dieses Merkmal klar herauszustellen. Der Schritt erfolgt nur für die Alternative zu Fig. 3G beschriebene Dotierung mit POCl₃. Bei einer Ionenimplantation läßt sich dieser komplexere Prozeß zur Ausbildung der gefalteten Kante 50A vermeiden. Eine weitere Vereinfachung ist durch konventionelle Plasmaätzung möglich.

In Fig. 3J ist die Struktur nach dem thermischen Aufwachsen von Siliciumdioxid auf der freiliegenden Fläche der Struktur gezeigt. Die Eintreibediffusion für Source/Drain und die fortgesetzte Oxidation werden in Dampf bei Temperaturen von 900 bis 1000° C fortgesetzt. So hat die Oxidschicht 41 eine Dicke von etwa 730 nm in dem mit 41A bezeichneten Teil und von 400 nm in dem mit 41 B bezeichneten Teil.

Fig. 3K zeigt die vierte Photomaske. Auf bekannte Weise wird mit Photolithographie und Oxidätzung der Ausschnitt 51 in der Oxidschicht 41 angebracht, der die Öffnung für die Gate-Elektrode bildet.

In Fig. 3L ist gezeigt, wie eine Siliciumdioxidschicht 52 mit einer Dicke von 50 bis 80 nm thermisch aufgewachsen wird. Die Schicht wird bekanntlich bei FET's als Gate-Dielektrikum bezeichnet. Die Elemente in den peripheren Schaltungen werden gleichzeitig geöffnet.

In Fig. 3M ist gezeigt, wie durch bekannte Photolithographie- und Ätztechniken weitere Kontaktöffnungen dort angebracht werden, wo sie in der monolithischen Speicherstruktur erforderlich sind. Eine Kontaktöffnung zur dotierten Polysiliciumschicht 49, die vorher als Referenzebene bezeichnet wurde, wird hier beispielsweise vorgesehen. Die AL-CU-Legierung für Gate und Verbindungsleitungen wird durch Aufdampfen niedergeschlagen und in bekannter Photolithographie-Ätztechnik definiert. Der resultierende Querschnitt ist in Fig. 3M gezeigt.

Die oben beschriebene Folge von Prozeßschritten verlangt ein Minimum an Photomaskierung zur Herstellung eines verbesserten erfindungsgemäßen monolithischen Speichers.

In den Fig. 4A bis 4F ist die Herstellung von Feldeffekttransistoren für Peripherieschaltungen des erfindungsgemäßen monolithischen Speichers gezeigt. Die dazu erforderlichen Herstellungsschritte werden gleichzeitig mit den oben im Zusammenhang mit den Fig. 3A bis 3M beschriebenen Schritten ausgeführt. Zur Herstellung des ganzen erfindungsgemäßen monolithischen Speichers dient natürlich nur ein Prozeß, der aus mehreren sequenziellen Prozeßschritten besteht.

Die in Fig. 4A gezeigte Oxidstruktur 41 entspricht der Struktur der Fig. 3 und die Oxidschicht 41 wird in demselben Prozeßschritt aufgebracht, der für die Fig. 3A beschrieben wurde.

Die in Fig. 4B gezeigte Struktur befindet sich in derselben Prozeßstufe wie die in Fig. 3B gezeigte Struktur. In der Oxidschicht 41 sind in einem bestimmten Abstand voneinander Ausschnitte 60 und 61 vorgesehen. Die Fig. 4B zeigt die Struktur desjenigen Teiles des monolithischen Speichers, der dort für die erste Photomaske gezeigt wurde.

Die in Fig. 4C dargestellte Struktur befindet sich auf derselben Prozeßstufe wie die in Fig. 3C gezeigte Struktur, es werden nämlich die N+-Bereiche 62 und 63 vorgesehen und die Oxidschicht 41 auf eine Dicke von ungefähr 500 nm erhöht.

Die in Fig. 4D gezeigte Struktur befindet sich auf derselben Prozeßstufe wie die Struktur der Fig. 3L. Nach Darstellung in Fig. 4D werden die Öffnungen 64, 65 und 66 für Drain, Gate bzw. Source vorgesehen und die dünnen Siliciumdioxidschichten 67, 68 und 69 thermisch aufgewachsen. Die Siliciumdioxidschichten sind ungefähr jeweils 50 nm dick.

Fig. 4E zeigt die Struktur im fünften Photomaskenschritt des Prozesses, in dem die dünnen Oxidschichten 67 und 69 entfernt werden.

Die in Fig. 4F gezeigte Struktur befindet sich auf derselben Prozeßstufe wie die in Fig. 3M gezeigte Struktur, wo das Metallgate des FET mit Kontakten zu Source und Drain ausgebildet wird.

## Patentansprüche

1. Hochintegrierte Speichermatrix aus jeweils einen Feldeffekttransistor (T1) enthaltenden Speicherzellen (MC) mit Speicherkondensatoren im Kreuzungspunkt von Wort-(WL) und Bitleitungen (BLL, BLR) auf einem Halbleitersubstrat (39), bei der auch die peripheren Schaltkreise und Decoder (1L, 1R, 2) mit auf dem Substrat in gleicher Technik aufgebracht sind und inhärente, durch die Struktur bedingte Kapazitäten vorhanden sind, die als Speicherkondensator benutzt und einerseits von dem Sourcebereich (31A) des Feldeffekttransistors sowie andererseits von einer aus dotiertem Polysilicium bestehenden Leiterreferenzschicht (34A) und dem Halbleitersubstrat (39) gebildet werden, wobei ein erster Teil dieser Leiterreferenzschicht eine Elektrode des Speicherkondensators selbst darstellt unterhalb der der Sourcebereich (31A) angeordnet ist, dadurch gekennzeichnet, daß ein zweiter Teil der Leiterreferenzschicht (34A) auf einer gegenüber dem ersten Teil dickeren, thermisch aufgewachsenen Siliciumdioxidschicht (32A) angeordnet ist, die ihrerseits parallel zu den Bitleitungen (30A) angeordnet ist und daß der erste Teil der Leiterreferenzschicht eine Fläche besitzt, die aus zwei Rechtecken zusammengesetzt ist, die nahezu die gleiche Länge, jedoch unterschiedliche Breite aufweisen, und auf einer gegenüber dem zweiten Teil dünneren Oxidschicht (40A) angeordnet ist, und daß das Gate-Dielektrikum und das Speicher-Dielektrikum ausschließlich aus Oxid bestehen.

2. Hochintegrierte Speichermatrix nach Anspruch 1, dadurch gekennzeichnet, daß das Gate-Dielektrikum (37) vorzugsweise Siliciumdioxid mit einer Dicke von ca. 50 nm (500 Angström) ist und die Gate-Elektrode (G) mit der Wortleitung (38A) integriert ausgebildet ist.

3. Hochintegrierte Speichermatrix nach Anspruch 2, dadurch gekennzeichnet, daß die Gate-Elektrode (G) etwa so lang ist wie der Abstand zwischen dem Drainbereich (30) und dem Sourcebereich (31A).

4. Verfahren zur Herstellung einer hochintegrierten Speichermatrix nach einem der Ansprüche 1 bis 3, dadurch gekennzeichnet, daß in einem feuchten Thermooxidationsprozeß auf dem Siliciumsubstrat (39) eine Siliciumdioxidschicht (41) aufgewachsen wird, daß dann zwei Ausschnitte (42 und 43) in die Siliciumdioxidschicht (41) geätzt werden, die als Maske für die Herstellung der Bitleitung bzw. des Drains und des Sourcebereiches einer jeden Speicherzelle dienen, daß eine N-Dotierung, vorzugsweise Phosphor, durch die gebildeten Ausschnitte (42 und 43) erfolgt und im Substrat (39) N+-Bereiche (44 und 45) gebildet werden, daß während des Aufwachsens eines weiteren Thermooxids die N-Verunreinigungen tiefer in das Substrat (39) eindiffundiert werden, daß danach ein dritter Ausschnitt (47), der die Lage des Speicher-Dielektrikums definiert, geätzt wird, daß eine Oxidschicht (48) in dem Ausschnitt (47) auf den als Sourcebereich dienenden N+-Bereich zur Bildung des Speicher-Dielektrikums thermisch aufgewachsen wird, daß eine Polysiliciumschicht (49) auf alle freiliegenden Flächen niedergeschlagen und dotiert wird, daß ein Teil einer darauf angeordneten Maskenschicht (50) weggeätzt wird, daß die geätzte Maskenschicht (50) als Maske zum Ätzen der Polysiliciumschicht (49) benutzt wird, wodurch ein Teil der Maskenschicht (50) als unterätzter Teil (50A) zurückgelassen wird.

## Claims

1. Highly integrated storage matrix consisting of memory cells (MC) each containing a field effect transistor (T1), with storage capacitors in the point of intersection of word (WL) and bit lines (BLL, BLR) on a semiconductor substrate (39), where the peripheral circuits and decoders (1L, 1R, 2) are applied on the substrate in the same technique, and where inherent structure-based capacitances are provided which are used as storage capacitor and formed on the one hand by the source region (31A) of the field effect transistor, and on the other by a conductor reference layer (34A) of doped polysilicon and the semiconductor substrate (39), a first part of this conductor reference layer representing an electrode of the storage capacitor itself below which the source region (31A) is provided, characterized in that a second part of the conductor reference layer (34A) is arranged on a thermally grown silicon dioxide layer (32A) which is thicker than the first part, and which itself is arranged in parallel to the bit lines (30A), and that the first part of the conductor reference layer comprises a plane which is composed of two rectangles which are of almost the same lenght but of different width, and that it is arranged on an oxide layer (40A) thinner than the second part, and that the gate dielectric and the storage dielectric are made exclusively of oxide.

2. Highly integrated storage matrix as claimed in claim 1, characterized in that the gate's dielectric (37) is made preferably of silicon dioxide with the thickness of approximately 50 nm (500 Angström), and that the gate electrode (G) is integrated with the word line (38A).

3. Highly integrated storage matrix as claimed in claim 2, characterized in that the gate electrode (G) is approximately as long as the distance between the drain region (30) and the source region (31A).

4. Method of making a highly integrated storage matrix as claimed in any one of claims 1 to 3, characterized in that in a moist thermal oxidation process on the silicon substrate (39) a silicon dioxide layer (41) is grown, that subsequently two windows (42 and 43) are etched into the silicon dioxide layer (41) which serve as a mask for making the bit line and the drain, and source regions, respectively of each memory cell, that an N-doping, preferably phosphorus, is carried out through the windows (42 and 43), and that N+ regions (44 and 45) are made in the substrate (39), that during the growth of a further thermal oxide the N-impurities are diffused more deeply into the substrate (39), that subsequently a third window (47) defining the position of the storage dielectric is etched, that an oxide layer (48) is thermally grown in the window (47) onto the N+ region serving as a source region to form the storage dielectric, that a polysilicon layer (49) is deposited on all exposed areas, and doped, that part of a mask layer (50) arranged thereon is etched off, that the etched mask layer (50) is used as a mask for the etching of the polysilicon layer (49) so that a part of the mask layer (50) remains as a sub-etched part (50A).

## Revendications

1. Matrice de mémoire hautement intégrée, faite de cellules de mémoire (MC) contenant chacune un transistor à effet de champ (T1), avec des condensateurs de mémoire au point de croisement des lignes de mots (WL) et des lignes de bits (BLL, BLR) sur un substrat semi-conducteur, le circuits et décodeurs périphériques (1L, 1R, 2) étant également appliqués sur ce substrat suivant la même technique, et des capacités inhérentes, conditionnées par la structure, étant présentes, lesquelles capacités sont utilisées comme condensateur de mémoire et sont formées d'une part par la zone de source (31A) du transistor à effet de champ et d'autre part par une couche de référence conductrice constituée de polysilicium dopé (34A) et par le substrat semi-conducteur (39); une première partie de ladite couche de référence conductrice représentant une électrode du condensateur de mémoire lui-même, en-dessous de laquelle est disposée la zone de source (31A), cette matrice de mémoire est caractérisée par le fait qu'une deuxième partie de la couche de référence conductrice (34A) est disposée sur une couche de dioxyde de silicium (32A), plus épaisse que la première partie et appliquée thermiquement, laquelle de son côté est disposée parallèlement aux lignes de bits (30A); que la première partie de la couche de référence conductrice possède une surface composée de deux rectangles qui présentent presque la même longueur, mais une largeur différente, et qu'elle est disposée sur une couche d'oxyde (40A) plus mince que la deuxième partie; et que le diélectrique de grille et le diélectrique de mémoire se composent exclusivement d'oxyde.

2. Matrice de mémoire hautement intégrée suivant la revendication 1, caractérisée par le fait que le diélectrique de grille (37) est formé de préférence de dioxyde de silicium ayant une épaisseur d'environ 50 nm (400 Å), et que l'électrode de grille (G) est formée de façon intégrée avec la ligne de mots (38A).

3. Matrice de mémoire hautement intégrée suivant la revendication 2, caractérisée par le fait que l'électrode de grille (G) est à peu près aussi longue que la distance entre la zone de drain (30) et la zone de source (31A).

4. Procédé de fabrication d'une matrice de mémoire hautement intégrée suivant l'une des revendications 1 à 3, caractérisé par le fait que, dans un processus de thermo-oxydation humide, une couche de dioxyde de silicium (41) est appliquée sur le substrat de silicium (39); qu'ensuite deux fenêtres (42 et 43) sont pratiquées par décapage dans la couche de dioxyde de silicium (41), fenêtres qui servent de masque pour la fabrication de la ligne de bits (ou du drain) et de la zone de source de chaque cellule de mémoire; qu'un dopage N (de préférence du phosphore) est effectué à travers les fenêtres formées (42 et 43), et qu'à l'intérieur du substrat (39) sont formées des zones N+ (44 et 45); que, pendant l'application d'un oxyde thermique supplémentaire, les impuretés sont diffusées plus profondément à l'intérieur du substrat (39); qu'ensuite un troisième fenêtre (47), définissant la position du diélectrique de mémoire, est pratiqué par décapage; qu'une couche d'oxyde (48) est appliquée thermiquement à l'intérieur du fenêtre (47), sur la zone N+ servant de zone de source, en vue de former le diélectrique de mémoire; qu'une couche de polysilicium (49) est déposée sur toutes les surfaces exposées, et est dopée; qu'une partie d'une couche de masque disposée au-dessus (50) est enlevée par décapage; et que la couche de masque décapée (50) est utilisée comme masque pour le décapage de la couche de polysilicium (49); ce qui laisse subsister une partie de la couche de masque (50) sous forme de partie décapée de façon sous-jacente (ou latérale) (50A).

BITABFRAGE-VERSTÄRKER

DATEN-AUSG.

DATEN-EING.

BLR1
BLR2
BLRm
3

BLL1
BLL2
BLLm

$WL\frac{n}{2}$
$MC1\frac{n}{2}$
$MC2\frac{n}{2}$
$MCm\frac{n}{4}$

$WL(\frac{n}{4}+1)$
$MC1(\frac{n}{4}+1)$
$MC2(\frac{n}{4}+1)$
$MCm(\frac{n}{4}+1)$

T2
T1
DL1
DL2
DCL1
DCL2
DCLm

WORT-LTG. - DECODIERER + -TREIBER

$WL\frac{n}{4}$
$MC1\frac{n}{4}$
$MC2\frac{n}{4}$
$MCm\frac{n}{4}$

MC11
MC21
MCm1
T1 S
G D

WL1
2
1L

BIT- LTG. - DEKODIERER +    -TREIBER

**FIG. 1A**

| FIG.1A | FIG.1B |

**FIG.1**

BITABFRAGE - VERSTÄRKER

1R

2

WORT-LTG.-DEKODIERER +TREIBER

WLn

$MC1n$

$MC2n$

$MCmn$

$MC1\left(\frac{3n}{4}+1\right)$

DCR1

DCR2

DCRm

DR1

DR2

$MC1\left(\frac{3n}{4}\right)$

$MC1\left(\frac{n}{2}+1\right)$

$MC2\left(\frac{n}{2}+1\right)$

$MCm\left(\frac{n}{2}+1\right)$

$WL\left(\frac{n}{2}+1\right)$

BLR1

BLR2

BLRm

FIG.1D

| FIG 1D | FIG. 1E | FIG. 1F |
|---|---|---|

FIG.1C

FIG. 1E

P5

P6

BLL1

BLR1

P2

+V

ABFRAGE-VERST.

+V

GEMEINSAMER SCHALTKREIS
FÜR m ABFRAGE-VERST.

TAKT

ZU DEN RESTLICHEN m-1
ABFRAGE-VERST.

0 001 986

FIG. 1F

ZELLE NR. 2  ZELLE NR. 1

FÜR ZELLE NR. 2  BIT-LTG. 30A  FÜR ZELLE NR. 1  WORT-LTG. 38 A
SPEICHER-KNOTEN    SPEICHER-KNOTEN

2A     37A        2A

G

33B       33A

31B   31A

WORT-LTG. 38 B

## FIG. 2

32C 38A METALL-WORT-LTG. 32B

G

33B      33A
34B      34A
40C 33B' 37 33A'  32A
  N+ N+ N+ 40B

P    39

31B  30 KANAL 35 31A 40A

## FIG. 2A

FIG. 3A

FIG. 3B

FIG. 3C

FIG. 3D

FIG. 3E

FIG. 3F

FIG. 3G

FIG. 3H

FIG. 3I

FIG. 3J

FIG. 3K

FIG. 3L

FIG. 3M

FIG. 4A

FIG. 4B

FIG. 4C

FIG. 4D

FIG. 4E

FIG. 4F